Europäisches Patentamt

European Patent Office

Office européen des brevets

(19)

(11) Publication number: **0 221 290**
**A2**

(12) # EUROPEAN PATENT APPLICATION

(21) Application number: **86112445.1**

(22) Date of filing: **09.09.86**

(51) Int. Cl.4: **H03M 1/06**

(30) Priority: **06.11.85 US 795791**

(43) Date of publication of application:
**13.05.87 Bulletin 87/20**

(84) Designated Contracting States:
**DE FR GB**

(71) Applicant: **Hewlett-Packard Company**
**Mail Stop 20 B-O 3000 Hanover Street**
**Palo Alto California 94304(US)**

(72) Inventor: **Baldwin, Gary**
**765 San Antonio Road, No. 80**
**Palo Alto California 94303(US)**
Inventor: **Hornak, Thomas**
**1 Coalmine View**
**Portola Valley California 94025(US)**

(74) Representative: **Patentanwälte Kohler -**
**Schwindling - Späth**
**Hohentwielstrasse 41**
**D-7000 Stuttgart 1(DE)**

(54) **Dual latch architecture for reducing clock feedthrough in digital-to-analog converters.**

(57) A high speed monolithic current switching digital-to-analog converter (DAC) is provided. The DAC includes input level shift clock and data drivers (401, 421), differential dual latches (403, 405), differential multiplexers (409) and high speed current switching cells (411). Utilizing complementary clocks at one-half the input data rate, data is effectively latched at each transition or edge of the clock pulse rather than at only the positive (or negative) going edge of the clock. Thus, feedthrough of the previously unused clock edge and perturbation in the DAC output caused by the unused clock edge is eliminated.

FIG 4

# DUAL LATCH ARCHITECTURE FOR REDUCING CLOCK FEEDTHROUGH IN DIGITAL-TO-ANALOG CONVERTERS

## Background of the Invention

The present invention relates generally to digital-to-analog converters (DACs).

A DAC consists essentially of a set of analog current-steering switches each controlled by one of the DAC's digital inputs. In an n-bit current switching DAC the digital input is an n-bit binary number, or word, and each bit has a corresponding weighted current. The weighted currents $I_1 \ldots , I_n$ are related by $I_k = 2^{k-1}I$, where k is an integer in the range of $1 \leq k \leq n$, where the $k^{th}$ weighted current corresponds to the $k^{th}$ bit of the n-bit binary word and where k = 1 corresponds to the least significant bit. For each bit which is equal to "1" a corresponding weighted current is coupled to the output of the DAC and for each bit which is equal to "0" a corresponding weighted current is not coupled to the output of the DAC. In this manner the current at the output of the DAC is the sum of the individual weighted currents coupled to the output of the DAC and the magnitude is proportional to the n-bit word input to the DAC.

All DACs have an inherent limitation that may cause troublesome transients or glitches to be superimposed on the DAC output signal. When a new input word is applied to the DAC input to replace the previous word, proper operation of the DAC requires a simultaneous change of logic states on all digital inputs. In practical digital systems, however, the arrival of logic signals at the DAC inputs will always be somewhat skewed, mainly due to non-uniform delays in the individual logic signal source circuitry and interconnecting wiring. Further, individual switch cells may turn on faster than other switch cells, turn on faster than off or off faster than on, or in some cases a mixture of both. During the time when logic inputs are changing (skew time), the analog portion of the DAC will produce a glitch.

The glitch will be most severe at the time of the major carry --when all logic inputs are changing. For a DAC, the single-count transition between 011 . . . 111 and 100 . . . 000 could produce an intermediate logic state (e.g., the worst case) of 000 . . . 000 or 111 . . . 111 during the skew interval. This momentary logic input will force the analog output of the DAC to slew towards either voltage extreme for the duration of the skew time. The higher the rate of succession of digital words - (i.e., the shorter the duration of each word at the DAC's input) the more significant the glitch becomes.

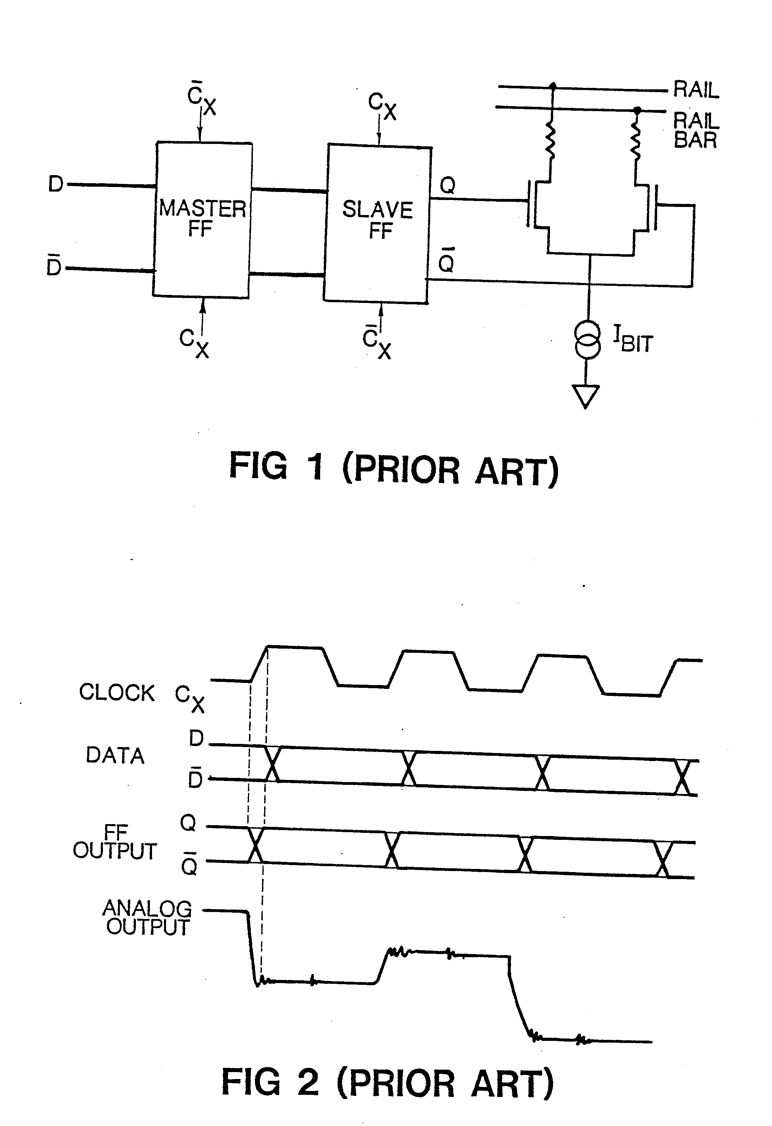

This skew time (caused by unequal turn-on/off times and bit transmission delays) can be minimized if all logic bits are loaded into a clocked storage register before transfer to the DAC. The simultaneous transfer of all bits into the DAC will limit skew times to those of the register and the DAC switches. Typically the register consists of a set of latches or master-slave flip-flops inserted between the digital inputs and the analog switches and is usually located in the immediate physical vicinity of the analog switches, preferably on the same monolithic chip. Figure 1 illustrates a one-bit cell of a typical master-slave architecture utilized to buffer the incoming data against variations in data arrival time. The DAC digital data inputs drive the data inputs of the master-slave flip-flops and the flip-flop outputs in turn drive the analog switches, in this example shown as MOS transistors, directing a weighted current to the DAC summing rails, RAIL and RAILBAR. The clock inputs of the flip-flops are all driven by a common clock signal whose phase is chosen so that its positive transition occurs prior to the most advanced data transition (the master-slave flip-flops are assumed to be positive-edge-triggered). The positive transition in the clock signal results in a transition in the flip-flop output signals which updates the output signals to become copies of the flip-flop input data. Because the flip-flops are all clocked by a common clock signal, the inputs to the analog switches occur simultaneously with negligible skew between the inputs and the DAC's output current controlled by the analog switches changes smoothly from a value representing one digital word to a value representing the next digital word.

However, the method of glitch removal has a drawback which may largely defeat the original purpose of the flip-flops, i.e., the removal of unwanted glitches from the DAC output signal. Since the flip-flops are positive-edge-triggered, the negative going edge of the clock represents an unavoidable "unused" transition of the clock signal. Due to the finite switching speeds of the flip-flops this unused clock transition cannot be moved arbitrarily close to the active data transitions, but must occur somewhere near the center of the word interval, i.e., in the center of the interval between two active data transitions. Consequently the unused clock transition will occur either in the analog switch's final stage of settling or after it has settled and the DAC output current is being utilized. Due to crosstalk between the flip-flops and the analog switches and elsewhere on the chip, as shown in Figure 2, the unused clock transition will cause a disturbance - (glitch) in the DAC output (analog output).

## Summary of the Invention

In accordance with the principles of the present invention, a high speed monolithic current switching digital to analog converter (DAC) is provided. The DAC integrated circuit (IC) comprises input ECL to MOS level shift clock and data converters, clock drivers, differential dual latch multiplexer data latches and high speed current switching cells. The DAC IC is designed for use in a 12-bit sampled DAC system which includes an NMOS buffer IC, external precision current sources and a gallium-arsenide (GaAs) sampler IC.

The DAC IC performs data synchronization and high speed current steering of binary weighted precision currents to a pair of differential output summing rails called RAIL and RAILBAR. The current switching cells utilize supplementary weighted currents to overcome the effects of long settling times due to parasitic capacitances as disclosed in U.S. Patent No. 4,405,916 issued to Thomas Hornak and Gary L. Baldwin on September 20, 1983, which is incorporated herein by reference. The data driver accepts ECL level data and provides complementary (i.e., 180° out of phase) MOS level data inputs to dual differential latches. The output of the dual latches is coupled to a differential multiplexer which selects the data to be coupled to the differential current switching cells. The dual latches and multiplexers require complementary clocks at one-half the input data rate. Thus, effectively, data is latched at each transition or edge of the clock pulse rather than at only the positive (or negative) going edge of the clock as in prior art systems. This eliminates feedthrough of the previously unused clock edge and hence any perturbation in the DAC output as is seen in the prior art.

The DAC utilizes an external current source to establish the required precision currents at the DAC output. The buffer IC provides additional isolation between the precision current source and the DAC IC current switching cells to achieve fast switching in the digital to analog conversion process. This buffers the impedance of the current source and decreases the capacitance seen by the DAC IC thereby decreasing the DAC settling time and increasing DAC speed.

The sampler IC samples the output of the DAC to remove any spurious signals or noise that may be present in the DAC output due to the DAC's nonlinear slewing and settling. The sampling switch is an on/off switch, rather than a sample and hold circuit. The sample switch has no holding capacitor to charge resulting in faster on/off switching and less error. The sampler current utilizes a differential architecture which steers the DAC's two outputs -- RAIL and RAILBAR --to load resistors via a balancing transformer (balun) or to ground or to a power supply return line via a dummy load resistor.

## Description of the Drawings

Figure 1 is a schematic diagram illustrating a prior art master-slave flip-flop architecture utilized in a current switching digital-to-analog converter.

Figure 2 is a diagram illustrating the perturbation of the analog output current waveform in the system shown in Figure 1.

Figure 3 is a block diagram of a digital-to-analog converter system according to the principles of the present invention.

Figure 4 is a functional block diagram illustrating the architecture of one of the twelve cells of the DAC IC shown in Figure 3.

Figures 5A and 5B illustrate logic diagrams for a conventional NOR latch and a NOR data multiplexer, respectively.

Figure 6 is a timing diagram for the DAC system shown in Figure 3.

## Description of the Preferred Embodiment

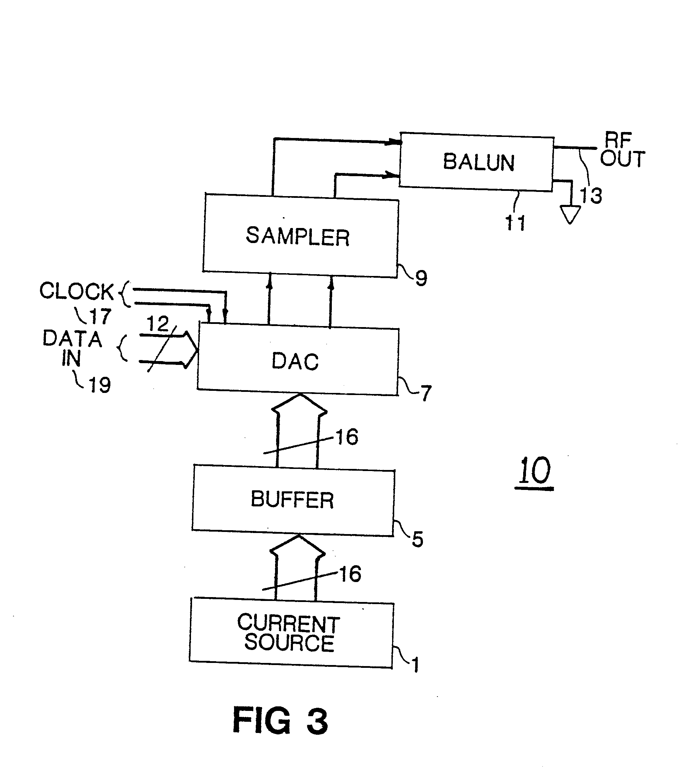

Referring now to figure 3, a digital-to-analog conversion system (DAC) 10 according to the principles of the present invention is illustrated. The DAC 10 comprises a monolithic NMOSFET current switching DAC IC 7, an NMOSFET buffer IC 5 and a gallium arsenide (GaAs) sampler IC 9 mounted in a multilayer, co-fired ceramic package. The circuitry for a sampler clock driver preamp is included on the sampler IC 9 chip. Included in the DAC 10 is a precision current source 1 and an output balun 11; the balun 11 provides a single-ended ac output on line 13 from the complementary differential outputs of the sampler 9. The data in 19 comprises ECL level, single ended 12-bit words. Latch clock 17 inputs a complementary ECL clock at one-half the frequency of the rate of input data. The sampler clock (not shown) is a complementary ECL signal at the same rate as the input data.

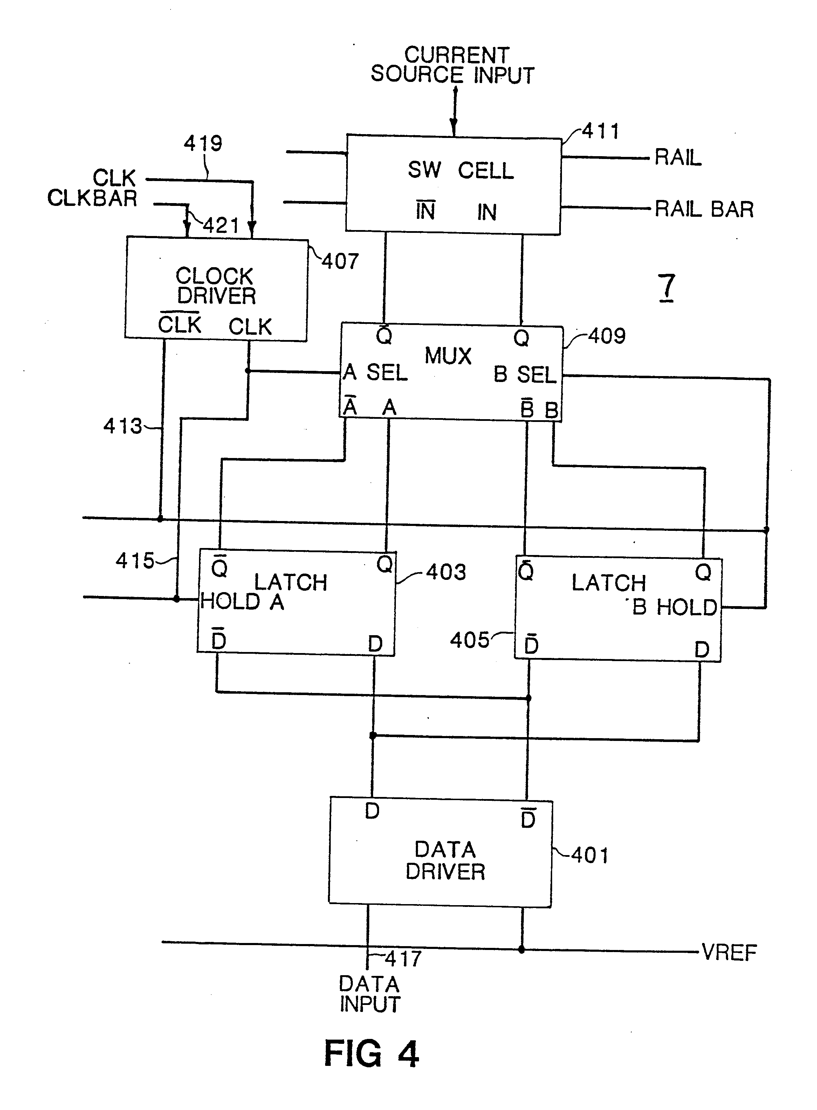

Referring now to Fig. 4, a functional block diagram of the DAC IC 7 for a single data bit is illustrated. The DAC IC 7 comprises a set of 12 such circuits or cells plus associated circuitry (not shown) to provide dynamic biasing. One clock driver 407 provides the latch clock signal to all 12 cells. The data driver 401 accepts a single-ended ECL data bit input on line 417 which is converted to complementary MOS level outputs to drive the dual data latches 403 and 405. The clock driver 407 accepts complementary ECL latch clock inputs, CLK and CLKBAR on lines 419 and 421 respectively, at one-half the data rate and provides complementary MOS latch clock outputs, CLK and CLKBAR on lines 415 and 413 respectively, to the data latches 403 and 405 and the multiplexer 409. The input data is latched into latch A 403 on the rising edge of the latch clock (CLK output on line 415 from clock driver 407) and is latched into latch B on the falling edge of the latch clock (rising edge of CLKBAR output on line 413 from clock driver 407). The output of latch A 403 is coupled to the A input port of multiplexer 409 and the output of latch B 405 is coupled to the B input port of multiplexer 409. The multiplexer 409 selects which latch outputs will drive the switch cell 411. The multiplexer 409 inputs A SEL and B SEL are clocked by the same clock driver 407 output, CLK and CLKBAR, which clocks latch A 403 and latch B 405, respectively. After the rising edge of CLK, latch A 403 is holding data and the multiplexer 409 selects the latch A 403 output; after the falling edge of CLK - (the rising edge of CLKBAR), latch B 405 is holding data and the multiplexer 409 selects the latch B 405 output. When the latch clock changes state at either edge, the latch that was holding data becomes transparent and the latch that was transparent latches the data set-up at its inputs. The multiplexer "reads" the output of each latch only after that output is holding a steady state value; at the same time, it blocks the output of the opposite latch. The clock feedthrough of the prior art associated with the previously "unused" falling edge of the latch clock will not occur in the multiplexer 409 outputs driving the precision current switch cell 411. The operation of the switch cell 411 is described in the aforementioned U.S. Patent No. 4,405,916 and will not be described here. The output of the DAC IC 7 on RAIL and RAILBAR (as shown in Fig. 4) is dc coupled to a high speed monolithic GaAs current steering sampler 9 (as shown in Figure 3).

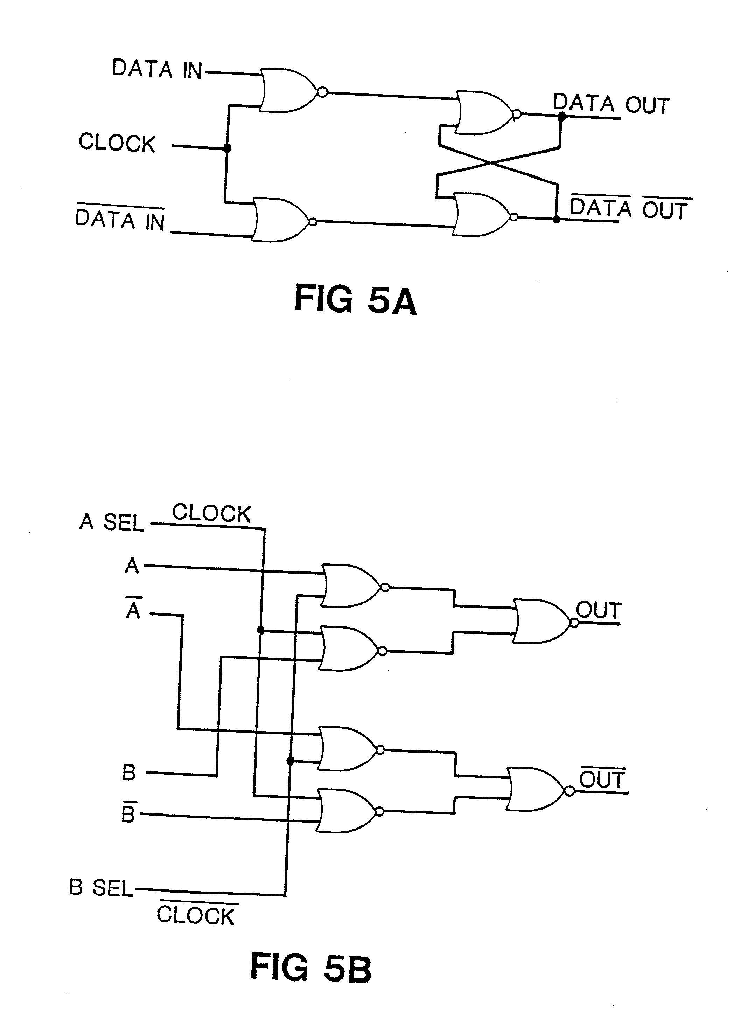

NOR transparent latch and NOR multiplexer configurations illustrated in Figures 5A and 5B respectively are utilized in the DAC IC 7. Complementary NOR logic was chosen in order to maximize logic symmetry and minimize glitches. Typicaiiy, complementary logic tends to produce lower amplitude glitches of shorter duration than single-ended logic and minimizes coupling to the outputs.

The sampler 9 (as shown in Fig. 3) comprises a current steering differential switch which is on the same monolithic chip as the sampler clock driver preamp (not shown). Also included on the same chip are resistive biasing for the ac coupled preamp and thirty-one diodes (not shown) to provide static and dynamic protection for the GaAs circuitry. The diodes clamp chip inputs to prevent turn on transients and excursions in power supplied and other external circuitry from damaging the on-chip devices.

The outputs of the sampler switch 9 are coupled to a balun 11 (as shown in Fig. 3) wherein the complementary ac outputs are subtracted. The balun 11 provides a single-ended ac output with excellent linearity and low spurious signal content. The balun 11 also rejects other undesirable system noise.

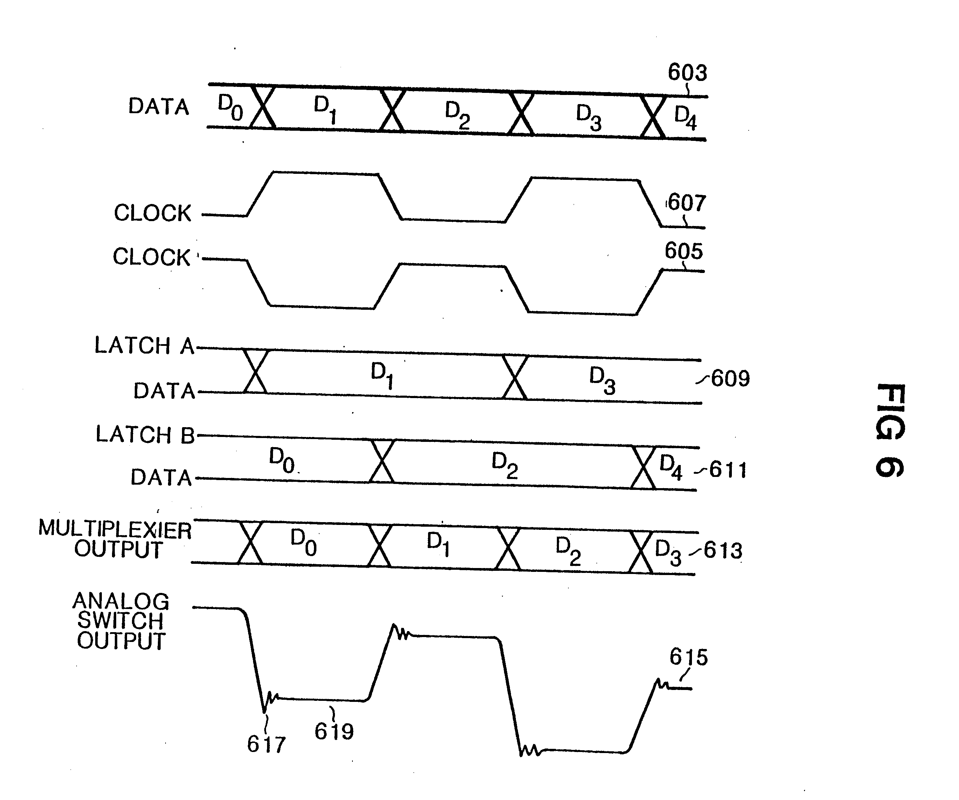

Referring now to Figs. 4 and 6, waveform 603 is the single-ended data input to the DAC data driver 401 on line 417 and waveforms 605 and 607 are the complementary clock and clockbar, respectively, outputs from the clock driver 407 on line 415 and 413 (i.e., the latch clock). The frequency of the latch clock 605, 607 is one-half the rate of the incoming data 603. Since during both phases of the latch clock 605 and 607 data is directed to the current switches, it is important that both phases of the latch clock have a 50% duty cycle. Both data registers 403 and 405 function as ordinary positive-edge triggered latches. Use of complementary clocks 605 and 607 in the above described results in data effectively input to switch cell 411 at the data rate utilizing both the rising and falling edges of a clock at one-half the input data rate.

Data is allowed to change immediately after any clock transition (i.e., zero hold time), but all data must be valid for at least 2 ns prior to the next clock edge for data to be latched. By delaying (or advancing) the clock signals 605 and 607 differences in the electrical paths between the data 603 and the clock 605, 607 can be compensated for to achieve maximum performance of the DAC. ECL complementary clocks are input on lines 419 and 421 and are buffered to MOS logic levels in the clock driver 407. The clock driver 407 consists of four dc coupled gain stages with a slew capability of 5 volts within 1 ns.

Latch A 403 is in the learning mode when clock 605 is low and its output 609 represents a copy of each odd bit, $D_1$, $D_3$ as shown in data waveform 603. When clock 605 is high, latch A 403 is in the memory mode. Similarly, when clockbar 607 is low, latch B 405 is in the learning mode and its output 611 represents a copy of each even bit. $D_0$, $D_2$, $D_4$ as shown in data waveform 603. The outputs 609, 611 of the latches 403 and 405 respectively drive the data inputs of multiplexer 409 and the control inputs of the multiplexer 409 are driven by clock 605 and clockbar 607. The output waveform 613 of multiplexer 409 is identical to its input latch A data 609 when clock 605 is high and is identical to its input latch B data 611 when clockbar 607 is high.

The multiplexer 409 output 613 drives the analog switches comprising switch cell 411. The analog switches switch a bit-weighted current supplied by a precision current source (not shown) between an output summing rail or railbar.

The analog switch output current waveform 615 is illustrated in Figure 6. Clock perturbations are confined to the edge 617 of the data transitions. Since, effectively, both edges of the latch clock are utilized there is no source of mid-data-point 619 perturbation, and a cleaner, faster DAC output is provided.

## Claims

1. An electronic apparatus for simultaneously inputting a plurality of logic bits comprising a logic word to a digital-to-analog converter and the like, said electronic apparatus comprising:
a plurality of input means, each of said input means for receiving an associated data bit of an n-bit data word at a predetermined data rate and providing a data signal, said data signal representative of said associated data bit;
a plurality of pairs of latch means, each pair of latches coupled to a different one of the data input means, said latch means responsive to a latch clock for latching the data signal, said latch clock rate being one-half the data rate, said latch means responsive to said latch clock to latch data at each transistion of the latch clock; and
a plurality of multiplexer means, each multiplexer means coupled to a different pair of said plurality of pairs of latch means, said multiplexer means responsive to each transition of the latch clock for selecting and coupling the data signal from said pair of latch means to the digital-to-analog converter.

2. An electronic apparatus as in claim 1 wherein said data signal comprises a pair of complementary data signals, and said latch clock comprises a first and a second latch clock signal, said first and second latch clock signals being 180 degrees out of phase.

3. An electronic apparatus as in claim 2 wherein each pair of said pairs of latch means comprise a pair of differential latch means coupled to said data input means, said pair of differential latches responsive to said first and second latch clock signals such that one latch means of said pair of latch means will latch said data signal representative of an associated data bit of said logic word on a rising edge of said first latch clock signal and the other latch means of said pair of latch means will latch said data signal representative of an associated data bit of a next successive logic word on the falling edge of said first latch clock, and each multiplexer means coupled to one pair of latch means, said differential multiplexer means responsive to said first and second latch clock signals for selecting and coupling said data signal from said pair of differential latch means to the digital-to-analog converter.

4. An n-bit current switching digital-to-analog converter of the type in which each weighted current $I_k$, $k = 1$, ..., n, of a set of n weighted currents has an associated current steering switch, said digital-to-analog con verter comprising:
a plurality of data input means, each data input means for receiving an associated data bit of an n-bit data word and providing a data signal representative of said associated data bit;
a plurality of pairs of latch means, each pair of latch means coupled to one of said plurality of data input means for latching said data signal, said plurality of pairs of latch means responsive to a latch clock, said latch clock rate one-half the input data rate, to latch said data signal at each transition of said latch clock;
a plurality of multiplexer means, each of said plurality of multiplexer means coupled to one of said plurality of pairs of latches, each of said plurality of multiplexer means coupled to an associated current steering switch and responsive to the latch clock for selecting and coupling the desired data signal from said pair of latch means to the associated current steering switch, at a predetermined data rate, said current steering switch responsive to said data signal to conduct $I_k$ to a first summing rail when the data signal is of a first value and to conduct $I_k$ to a second summing rail when the data signal is of a second value; and
precision current source means coupled to said current steering switches for providing said set of n weighted currents.

5. An n-bit current switching digital-to-analog converter as in Claim 4 further comprises:
a latch clock input means for receiving a complementary ECL level latch clock input and providing complementary MOS level first and second latch clocks to drive said plurality of pairs of latch means and said plurality of multiplexer means, said first and second latch clocks 180 degrees out of phase;
each of said plurality of data input means receives an ECL level signal representing said associated data bit of said n-bit data word and provides said data signal, said data signal comprising complementary MOS level data signals representing said associated data bit;
each of said plurality of pairs of latch means comprise a pair of differential latch means coupled to said data input means and to said latch clock input means, said pair of differential latches responsive to said complementary latch clocks such that one latch means of said pair of latch means will latch said data signal representative of a first associated data bit on a rising edge of said first latch clock and the other latch means of said pair of latch means will latch said data signal representative of the associated data bit of the next successive n-bit word on the falling edge of said first latch clock; and

each of said plurality of multiplexer means comprises a differential multiplexer means, each of said plurality of multiplexer means coupled to a different one of said plurality of pairs of differential latch means and to said latch clock input means, said differential multiplexer means responsive to the complementary first and second latch clocks for selecting and coupling the data signal from said pair of differential latch means to the associated current steering switch.

FIG 1 (PRIOR ART)

FIG 2 (PRIOR ART)

**FIG 3**

FIG 4

DATA IN

CLOCK

$\overline{\text{DATA IN}}$

DATA OUT

$\overline{\text{DATA}}\ \overline{\text{OUT}}$

## FIG 5A

A SEL — $\overline{\text{CLOCK}}$

A

$\overline{A}$

B

$\overline{B}$

B SEL

$\overline{\text{CLOCK}}$

OUT

$\overline{\text{OUT}}$

## FIG 5B

FIG 6

0 221 290